# DEMANDE DE BREVET EUROPEEN

(11) **EP 0 889 686 A1**
(43) Date de publication de la demande: **07.01.1999**
(21) Numéro de dépôt: 98401610.5
(22) Date de dépôt: 29.06.1998
(51) Int. Cl.: H05K 9/00

(54) **Dispositif d'étanchéité électromagnétique pour paroi mobile**

(30) Priorité: 30.06.1997 FR 9708217
(71) Demandeur: ALCATEL ALSTHOM COMPAGNIE GENERALE D'ELECTRICITE, 75008 Paris (FR)
(72) Inventeur: Tourneux, Bruno, 17100 Saintes (FR)
(74) Mandataire: Fournier, Michel Robert Marie

(57) **Abrégé**

On présente un dispositif d'étanchéité électronagnétique formé par un joint monté dans un logement (8) d'une paroi (7), ce joint étant pourvu d'au moins une lame ressort (20, 30) prévue pour pénétrer dans un emplacement de contact (E) destiné à recevoir un couteau (5).

Ce joint est monté mobile dans le logement (8) entre une position de repos dans laquelle la lame ressort (20, 30) est en dehors de l'emplacement de contact (E) et une position de travail dans laquelle cette lame ressort (20, 30) pénètre dans cet emplacement de contact (E), cette position de travail étant celle du joint lorsque le couteau (5) figure dans l'emplacement de contact (E).

## Description

La présente invention concerne un dispositif d'étanchéité électromagnétique incorporé à une paroi mobile par rapport à une autre paroi.

Il s'agit d'assurer la compatibilité électromagnétique d'enceintes renfermant des équipements électriques ou électroniques. En d'autres termes, il est nécessaire qu'une telle enceinte constitue une cage de Faraday pour réaliser un blindage efficace de ces équipements vis-à-vis d'un rayonnement électromagnétique.

Lorsque ces enceintes sont closes à demeure, il n'y a pas de difficultés particulières pour réaliser l'étanchéité électromagnétique de la cage de Faraday. Par contre, il est souvent nécessaire de prévoir un accès à l'intérieur de ces enceintes pour permettre le réglage ou la maintenance des équipements. On pense par exemple aux armoires, bâtis, coffrets, containers ou chambres anéchoïdes pourvus d'une paroi mobile ou semi-mobile telle qu'une porte. Dans ce cas, l'efficacité du blindage dépend directement de la qualité des contacts électriques entre la paroi mobile et la ou les parois fixes de l'enceinte.

Il est ainsi connu d'utiliser des joints à effet ressort, ce qu'enseigne notamment le brevet européen publié sous le numéro EP 0 253 203 B1. Dans ce document, l'une des parois est pourvue d'une rainure dont la section transversale a la forme d'un trapèze, la grande base de ce trapèze figurant à l'entrée de la rainure. Le joint proprement dit est formé par deux lames ressorts fixés sur les flancs de la rainure et dirigés vers l'intérieur de celle-ci. L'autre paroi est pourvue d'un couteau dont l'épaisseur est supérieure à la distance séparant les deux lames ressorts. Ainsi, lorsque le couteau est engagé dans la rainure, il vient presser sur les deux lames, assurant de fait le contact électrique requis.

On sait que la qualité du contact dépend essentiellement du matériau qui figure à la surface des lames et du couteau ainsi que de la pression appliquée. Pour les joints de ce type, les surfaces de contact sont soumises à un frottement important lors de l'introduction du couteau dans la rainure, ce qui tend à les dégrader. La dégradation est d'autant plus importante que la pression appliquée est élevée. D'autre part, l'effort à fournir pour l'insertion ou l'extraction du couteau dépend directement de la pression appliquée et de la longueur du joint.

La présente invention a donc pour objet un dispositif d'étanchéité électromagnétique monté dans une paroi et prévu pour coopérer avec un couteau solidaire d'une autre paroi, dispositif qui diminue sensiblement l'usure des surfaces de contact et l'effort nécessaire à l'assemblage des deux parois.

Le dispositif d'étanchéité électromagnétique est formé par un joint monté dans un logement d'une paroi, ce joint étant pourvu d'au moins une lame ressort prévue pour pénétrer dans un emplacement de contact destiné à recevoir un couteau ; selon l'invention, le joint est monté mobile dans ce logement entre une position de repos dans laquelle la lame ressort est en dehors de l'emplacement de contact et une position de travail dans laquelle cette lame ressort pénètre dans cet emplacement de contact, cette position de travail étant celle du joint lorsque le couteau figure dans l'emplacement de contact.

Ainsi, lorsque le couteau est introduit dans le logement, aucun effort n'est appliqué tant que le joint est dans sa position de repos. La pression est appliquée seulement lorsque ce joint passe de la position de repos à la position de travail.

Avantageusement, le logement présentant une section transversale comprenant un premier trapèze dont la grande base figure à la surface de la paroi, le joint présente une section transversale comprenant un deuxième trapèze déformable de hauteur égale et de petite base inférieure aux dimensions correspondantes du premier trapèze, la lame ressort dirigée vers l'intérieur du deuxième trapèze prenant naissance à une extrémité de la grande base de ce deuxième trapèze, la grande base du deuxième trapèze étant supérieure respectivement inférieure à la grande base du premier trapèze lorsque le joint est dans sa position de repos respectivement dans sa position de travail.

Suivant une caractéristique préférentielle, ce logement prend la forme d'une rainure et le fond de cette rainure correspond à la petite base du premier trapèze.

De plus, le dispositif comprend des moyens de liaison pour relier de manière souple la base du joint qui correspond à la petite base du deuxième trapèze et le fond de la rainure.

Selon un premier mode de réalisation, ces moyens de liaison sont constitués par au moins une patte flexible solidaire de la base du joint.

Selon un deuxième mode de réalisation, ces moyens de liaison sont constitués par une pièce de liaison mobile prenant appui d'une part sur la base du joint et d'autre part sur une surface d'appui disposée en regard de la rainure sur la face de la paroi qui est opposée à celle où figure cette rainure.

Dans ce cas, une solution particulièrement efficace vis-à-vis du problème posé consiste à coupler la pièce de liaison à une came qui prend appui sur la surface d'appui, cette came étant mobile entre deux positions qui déterminent les positions de repos et de travail du joint.

L'intérêt de cette solution réside dans le fait que la pression de contact n'est appliquée que lorsque le couteau est dans sa position finale, l'enceinte étant déjà fermée.

La présente invention apparaîtra maintenant avec plus de détails dans le cadre de la description qui suit d'exemples de réalisation données à titre illustratif en se référant aux figures annexées qui représentent:
- la figure 1 , une vue perspective d'un joint adapté à la mise en oeuvre de l'invention,
- la figure 2 , une vue de côté de ce joint,
- la figure 3 ,une coupe transversale d'un premier mode de réalisation de l'invention, le joint en position de repos,
- la figure 4 ,la même coupe que la figure 3 avec le joint en position de travail,
- la figure 5 , une coupe transversale d'un deuxième mode de réalisation de l'invention, le joint en position de repos, et
- la figure 6 , la même coupe que la figure 5 avec le joint en position de travail.

Les éléments présents dans différentes figures sont affectés d'une seule et même référence.

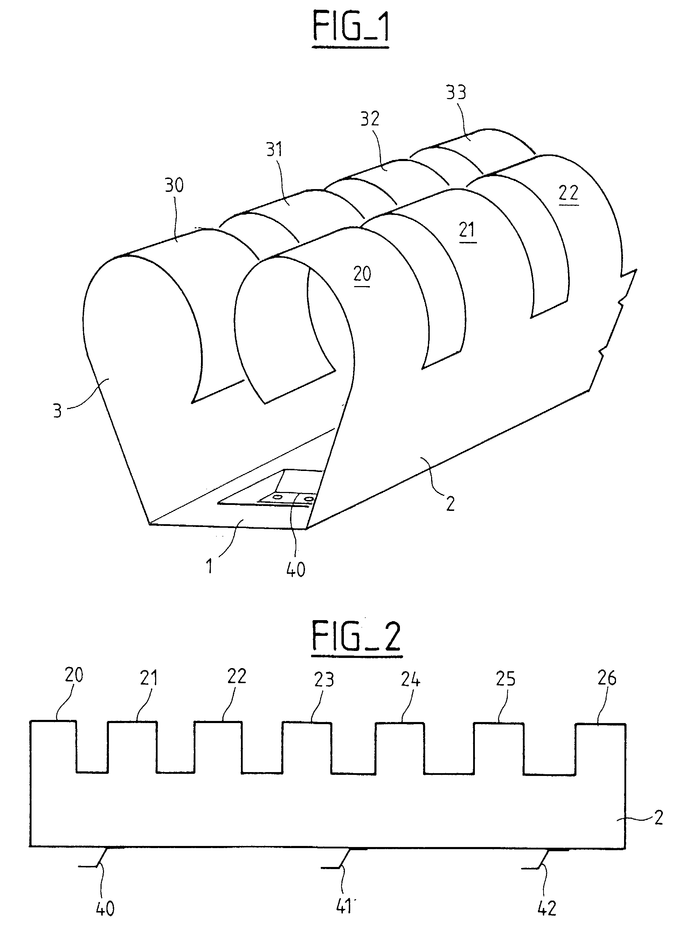

Un joint susceptible d'être utilisé pour la mise en oeuvre de l'invention est représenté en perspective dans la figure 1 et vu de son côté droit par rapport à cette perspective dans la figure 2. Il comprend une base rectangulaire 1 prolongée par un flanc droit 2 sur son grand côté droit et un flanc gauche 3 sur son grand côté gauche. Les angles que font le flanc droit et le flanc gauche avec la base sont sensiblement égaux. Le flanc droit 2 est prolongé par une pluralité 20, 21, ..., 26 de lames ressorts du côté opposé à la base 1. Ces lames ressorts successivement alignées prennent donc naissance sur le flanc droit et sont recourbées en direction de la base 1. Le joint étant ici symétrique par rapport au plan perpendiculaire à la base et passant par son axe longitudinal, le flanc gauche est également prolongé par une pluralité correspondante de lames ressorts 30, 31, ..., 33. Le joint est aussi pourvu de plusieurs pattes 40, 41, 42 qui sont réalisées par usinage de la base 1. Ces pattes qui s'étendent à partir de la base vers l'extérieur du joint sont destinées à la fixation.

Le joint est réalisé dans un matériau ressort car son bon fonctionnement implique que les flancs, les lames ressorts et les pattes agissent comme des ressorts.

D'autre part, la largeur et l'espacement des lames ressorts sont calculés en fonction des fréquences du rayonnement électromagnétique qu'il convient d'écranter. A ce sujet, on prévoit une pluralité de lames élémentaires sur chaque flanc de sorte que le joint présente une souplesse convenable. L'invention s'appliquerait également si l'on prévoyait une lame unique de même longueur que le flanc, c'est-à-dire si l'on réduisait à néant les espacements qui figurent entre les lames élémentaires adjacentes. De même que l'on retienne la solution d'une pluralité de lames élémentaires ou celle d'une lame unique, l'invention s'applique aussi si seul un des deux flancs est pourvu de ces lames élémentaires ou de cette lame unique, bien qu'il faille s'attendre à une moins bonne efficacité du blindage électromagnétique.

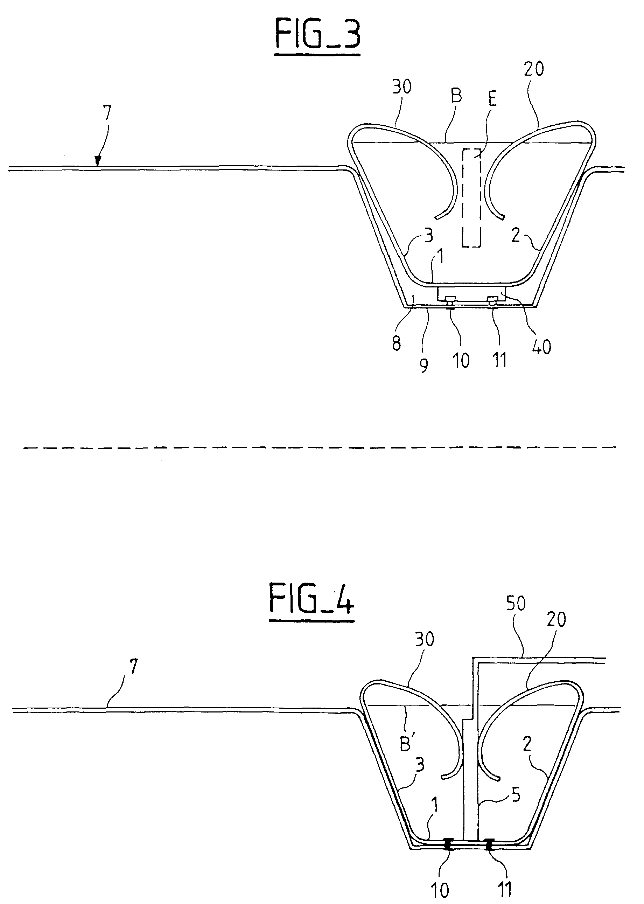

En référence à la figure 3 , un premier mode de réalisation du dispositif d'étanchéité électromagnétique est détaillé en coupe transversale. Le dispositif comporte, dans une paroi 7 , une rainure 8 .Cette rainure se présente sous la forme d'un premier trapèze dont la petite base 9 correspond au fond de la rainure.

Le joint précédemment décrit est fixé au fond de la rainure, par exemple au moyen de deux rivets 10, 11 traversant une patte 40 de ce joint. Ce joint est ici représenté dans une position de repos où sa base est située au dessus du fond de la rainure , de quelques millimètres par exemple. Cette position stable est due d'une part à la fixation des pattes et d'autre part à l'effet ressort tant de ces pattes que des flancs du joint. On remarque que si l'on rejoint les flancs par un segment de droite B imaginaire (figuré en trait fin) parallèle à la base 1 du joint, on peut alors définir un deuxième trapèze dont la petite base est la base 1 du joint, la grande base est ce segment imaginaire B ,les deux autres côtés sont supportés par les flancs 2, 3 et la hauteur est égale à la profondeur de la rainure 8 c'est-à-dire à la hauteur du premier trapèze. La base 1 du joint est plus petite que le fond de la rainure 8 qui correspond à la petite base 9 du premier trapèze. Dans cette position de repos , la grande base B du deuxième trapèze est plus grande que la grande base du premier trapèze.

On peut également délimiter un emplacement de contact E qui figure entre les parties recourbées des lames ressorts 20, 30. Cet emplacement de contact qui est totalement dégagé est prévu pour être occupé par un couteau, ce qui va être maintenant explicité.

La paroi 7 dans laquelle figure le joint est prévue pour être assemblée avec une autre paroi portant un couteau. Lors de l'assemblage, le couteau se déplace relativement au joint, sensiblement dans un plan perpendiculaire à la rainure 8 qui passe par l'axe longitudinal de cette rainure. Le couteau vient donc s'engager entre les lames 20, 30 puis il vient occuper l'emplacement de contact E jusqu'à s'appliquer contre la base 1 du joint lorsqu'il est dans sa position de repos. Jusqu'à ce point du déplacement relatif du couteau, les lames ressorts sont en dehors de l'emplacement de contact si bien qu'il n'y a eu aucun frottement entre ces lames et le couteau. L'intérêt de l'invention apparaît ici très clairement.

Lorsque le couteau affleure la base 1 du joint, un effort appliqué sur l'une des parois par rapport à l'autre presse le couteau sur la base de sorte que cette base vienne pratiquement au contact du fond de la rainure 8, ce qui correspond à la position de travail du joint.

En référence à la figure 4, le dispositif est représenté avec le joint dans cette position de travail, enserrant le couteau 5 solidaire d'une paroi 50. Naturellement, les deux parois 7, 50 sont immobilisées par des moyens non représentés.

On remarque que suite à l'appui du couteau, le joint est entraîné vers le fond de la rainure et se déforme pour amener les lames ressorts 20, 30 au contact du couteau 5. En effet, dans cette position de travail, la grande base B' du deuxième trapèze qui est déformable est maintenant d'une dimension sensiblement égale à celle de la grande base du premier trapèze. La diminution de la grande base du deuxième trapèze a bien pour effet de rapprocher les lames ressorts.

En résumé, dans une première phase, le couteau est amené au contact du joint sans qu'il n'y ait un quelconque frottement et, dans une deuxième phase, la pression de contact est appliquée sur les lames ressorts lors du déplacement relativement court du joint de sa position de repos à sa position de travail.

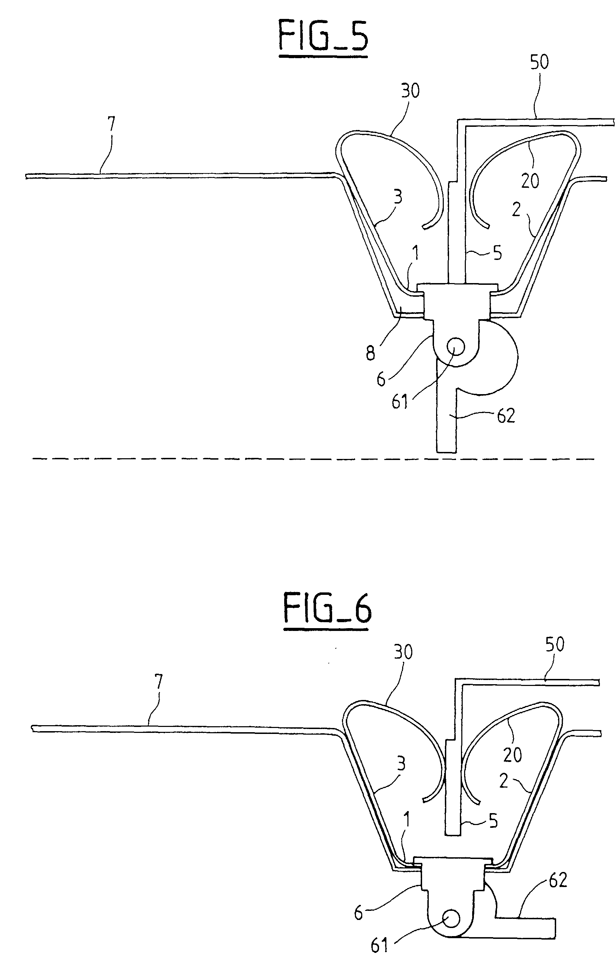

En référence à la figure 5, un deuxième mode de réalisation du dispositif objet de l'invention est représenté lorsque le joint est dans sa position de repos. Ce joint est identique à celui du mode de réalisation précédent si ce n'est qu'il n'a pas de pattes prévues pour la fixation à la paroi 7. La fixation est ici réalisée par une pièce de liaison mobile 6 qui prend appui d'un côté sur la face supérieure de la base 1 du joint grâce à une ouverture ménagée dans cette base. L'autre côté de cette pièce de liaison traverse partiellement la paroi 7 au niveau du fond de la rainure et présente un axe 61 qui se trouve donc à l'extérieur de cette paroi, à proximité de la face opposée à celle de la rainure. Cet axe 61 est l'axe de rotation d'une came 62 qui prend appui sur la paroi. Dans cette position d'ouverture, cette came maintient le joint dans sa position de repos.

Lors de l'assemblage des deux parois, le couteau 5 est engagé dans la rainure 8 jusqu'à venir affleurer la partie supérieure de la pièce de liaison 6, les deux parois étant alors immobilisées par des moyens non représentés dans la position qui correspond à la fermeture de l'enceinte. Cette position de fermeture a été atteinte sans qu'il n'y ait eu un quelconque frottement entre les lames ressorts et le couteau.

En référence à la figure 6, le joint est placé dans sa position de travail en manoeuvrant la came 62, ce qui a pour effet ici aussi de venir plaquer la base 1 du joint sur le fond de la rainure 8.

On remarque que, mis à part les moyens de liaison qui prennent une forme différente, le mode de fonctionnement du deuxième mode de réalisation est tout à fait similaire à celui du premier mode décrit plus haut. Ce deuxième mode de réalisation présente par contre l'avantage de n'appliquer la pression du contact qu'une fois que le couteau est dans sa position définitive. un tel dispositif permet d'obtenir un blindage efficace pour des fréquences supérieures à 1 GHz.

Il faut noter par ailleurs que l'invention ne se limite pas aux modes de réalisation ci-dessus. A titre d'exemple et plus généralement, la rainure peut prendre la forme d'un logement quelconque fermé ou même traversant la paroi. Dans ce dernier cas, on pourra prévoir des moyens de liaison prenant appui sur l'un ou les deux flancs du joint.

L'homme du métier comprend bien que de nombreuses variantes de mise en oeuvre de l'invention sont disponibles et qu'il ne serait pas possible de toutes les énumérer. Le point essentiel est la fixation mobile d'un joint dans un logement entre une position de repos où ce joint n'est pas en contact avec le couteau et une position de travail dans laquelle le joint fait pression sur ce couteau.

## Revendications

1. Dispositif d'étanchéité électromagnétique formé par un joint monté dans un logement (8) d'une paroi (7), ce joint étant pourvu d'au moins une lame ressort (20, 30) prévue pour pénétrer dans un emplacement de contact (E) destiné à recevoir un couteau (5), caractérisé en ce que ledit joint est monté mobile dans ce logement (8) entre une position de repos dans laquelle ladite lame ressort (20, 30) est en dehors dudit emplacement de contact (E) et une position de travail dans laquelle cette lame ressort (20, 30) pénètre dans cet emplacement de contact (E), cette position de travail étant celle du joint lorsque ledit couteau (5) figure dans ledit emplacement de contact (E).

2. Dispositif selon la revendication 1 caractérisé en ce que, ledit logement (8) présentant une section transversale comprenant un premier trapèze dont la grande base figure à la surface de ladite paroi (7), ledit joint présente une section transversale comprenant un deuxième trapèze déformable de hauteur égale et de petite base (1) inférieure aux dimensions correspondantes dudit premier trapèze, ladite lame ressort (20, 30) dirigée vers l'intérieur dudit deuxième trapèze prenant naissance à une extrémité de la grande base (B) de ce deuxième trapèze, la grande base dudit deuxième trapèze étant supérieure respectivement inférieure à la grande base dudit premier trapèze lorsque le joint est dans sa position de repos respectivement dans sa position de travail.

3. Dispositif selon la revendication 2 caractérisé en ce que, ledit logement (8) prenant la forme d'une rainure, le fond de cette rainure correspond à la petite base (9) dudit premier trapèze.

4. Dispositif selon la revendication 3, caractérisé en ce qu'il comprend des moyens de liaison (40, 6, 62) pour relier de manière souple la base (1) du joint qui correspond à la petite base dudit deuxième trapèze et le fond de ladite rainure (8).

5. Dispositif selon la revendication 4, caractérisé en ce que lesdits moyens de liaison sont constitués par au moins une patte flexible (40) solidaire de la base du joint.

6. Dispositif selon la revendication 4, caractérisé en ce que lesdits moyens de liaison sont constitués par une pièce de liaison mobile (6) prenant appui d'une part sur la base (1) du joint et d'autre part sur une surface d'appui disposée en regard de ladite rainure (8) sur la face de ladite paroi qui est opposée à celle où figure cette rainure (8).

7. Dispositif selon la revendication 6, caractérisé en ce que ladite pièce de liaison (6) est couplée à une came (62) qui prend appui sur ladite surface d'appui, cette came (62) étant mobile entre deux positions qui déterminent les positions de repos et de travail dudit joint.
